# EUROPÄISCHE PATENTSCHRIFT

(11) **EP 3 607 592 B1**
(45) Veröffentlichungstag und Bekanntmachung des Hinweises auf die Patenterteilung: **28.05.2025**
(21) Anmeldenummer: 18720088.6
(22) Anmeldetag: 04.04.2018
(51) Int. Cl.: H02N 2/00, H02N 2/02, H02N 2/10

(54) **VERFAHREN ZUM BETREIBEN EINES ULTRASCHALLMOTORS**
METHOD FOR OPERATING AN ULTRASONIC MOTOR
PROCÉDÉ DE FONCTIONNEMENT D'UN MOTEUR À ULTRASONS

(30) Priorität: 05.04.2017 DE 102017107275
(43) Veröffentlichungstag der Anmeldung: 12.02.2020
(73) Patentinhaber: Physik Instrumente (PI) SE & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Grünecker Patent- und Rechtsanwälte PartG mbB
(86) Internationale Anmeldenummer: PCT/DE2018/100301
(87) Internationale Veröffentlichungsnummer: WO 2018/184634

(56) Entgegenhaltungen:
- DE-A1- 102014 205 577
- DE-B4- 102005 010 073
- US-A- 5 616 980
- US-A1- 2004 017 134
- US-A1- 2016 049 572

## Beschreibung

Die Erfindung betrifft ein Verfahren zum Betreiben eines Ultraschallmotors gemäß den Ansprüchen 1 bis 4.

Aus der DE 10 2005 010 073 B4 ist ein Verfahren zum Ansteuern bzw. zum Betreiben eines Ultraschallmotors bekannt, bei dem die Bewegungssteuerung des anzutreibenden Elements durch die in seinem in Form einer rechteckigen Platten vorliegenden Ultraschallaktuator erzeugten akustischen Stehwellen und durch das statische Biegen des Ultraschallaktuators erfolgt.

Dabei werden in dem Ultraschallaktuator sowohl akustische Biege-Stehwellen, die sich entlang seiner Länge L und entlang seiner Höhe H ausbreiten, als auch akustische Längs-Stehwellen, die sich entlang seiner Länge L ausbreiten, erzeugt.

Die Dicke B der piezoelektrischen Platte des Ultraschallaktuators ist aus technischen Gründen auf den Wert H/4 begrenzt, weswegen es bei dem aus der DE 10 2005 010 073 B4 bekannten Ultraschallmotor unmöglich ist, eine Länge des Friktionskontakts zu realisieren, die größer als H/4 ist. Dadurch sind die maximale durch den Ultraschallmotor erzeugbare Kraft und die entsprechende mechanische Leistung begrenzt.

Wenn die Anforderung nach höheren Antriebskräften bzw. nach höheren mechanischen Leistungen besteht, können zwei oder mehr parallel geschalteter bzw. gekoppelter Ultraschallmotoren eingesetzt werden.

Ein Nachteil bei einer solchen Kopplung besteht jedoch darin, dass in der Praxis die Ultraschallmotoren eine relativ große Streuung hinsichtlich der Betriebs-(Resonanz-)Frequenzen aufweisen. Das ist auf die bei der Fertigung der Ultraschallaktuatoren auftretende und technologisch bedingte Streuung der Dichte und Härte der piezoelektrischen Keramik zurückzuführen.

Der Unterschied in den Betriebsfrequenzen der einzelnen Ultraschallmotoren führt zur Verringerung der Gesamtleistung der parallel geschalteten Ultraschallmotoren und zu einem instabilen Betrieb aufgrund einer Übertragung bzw. eines Übergangs der Betriebsfrequenz eines Motors auf einen anderen Motor.

Ferner ist die Verwendung mehrerer Motoren mit höheren Kosten verbunden.

Andere Aktorkonzepte mit mehreren aktiven Teilbereichen sind zum Beispiel aus der US 2004/017134 A1, der US 5 616 980 A oder der DE 10 2014 205577 A1 ersichtlich.

Es ist daher Aufgabe der Erfindung, ein Verfahren zum Betreiben eines Ultraschallmotors bereitzustellen, mit welchem gegenüber den aus dem Stand der Technik bekannten Verfahren ein Ultraschallmotor mit einer höheren Antriebskraft, einer höheren mechanischen Leistung und einer höheren Betriebsstabilität realisiert werden kann.

Diese Aufgabe wird gelöst mit einem Verfahren zum Betreiben eines Ultraschallmotors gemäß Anspruch 1, wobei die sich daran anschließenden Unteransprüche 2 bis 4 mindestens zweckmäßige Weiterbildungen darstellen.

Das erfindungsgemäße Verfahren untergliedert sich in folgende Schritte:
- Bereitstellen eines Ultraschallaktuators aus einem piezoelektrischen oder elektrostriktiven oder magnetostriktiven Material in Form einer Platte, deren Breite B größer als deren Dicke D und kleiner als deren Länge L ist, und die Platte zwei Hauptflächen, zwei sich entlang der Länge erstreckende Seitenflächen und zwei sich entlang der Breite erstreckende Stirnflächen aufweist, und die eine Quersymmetrieebene S1, die senkrecht zu den Hauptflächen und den Seitenflächen und parallel zu den Stirnflächen verläuft, und eine Längssymmetrieebene S2, die senkrecht zu den Seitenflächen und den Stirnflächen und parallel zu den Hauptflächen verläuft, besitzt, wobei an wenigstens einer der Stirnflächen des Ultraschallaktuators ein zu einem Kontakt mit einem anzutreibenden Element vorgesehenes Friktionselement angeordnet ist, und der Ultraschallaktuator vier identische Volumenbereiche umfasst, die sowohl symmetrisch bezüglich der Quersymmetrieebene S1 als auch symmetrisch bezüglich der Längssymmetrieebene S2 angeordnet sind, und jeder der Volumenbereiche zusammen mit an und/oder in dem Ultraschallaktuator angeordneten Erregerelektroden und allgemeinen Elektroden sowohl einen Generator zur Ausbildung akustischer Stehwellen, als auch einen Generator zur Ausbildung statischer Biegedeformationen bildet;
- Bereitstellen einer elektrischen Erregervorrichtung, welche nur eine elektrische Wechselspannung U1 oder aber zwei elektrische Wechselspannungen U1, U2 und zudem zwei statische elektrische Spannungen E1, E2 liefert;
- Anlegen der Wechselspannung U1 an die Elektroden von zwei der vier Generatoren G1, G2, G3, G4 oder Anlegen einer der beiden Wechselspannungen U1, U2 an die Elektroden von zwei der Generatoren G1, G2, G3, G4 und Anlegen der anderen Wechselspannung U1, U2 an die Elektroden der beiden anderen Generatoren G1, G2, G3, G4 zur Ausbildung einer akustischen Stehwelle in dem Ultraschallaktuator in einem dynamischen Betriebsmodus, oder Anlegen einer der beiden statischen elektrischen Spannungen E1, E2 an die Elektroden von zwei der vier Generatoren G1, G2, G3, G4 und Anlegen der anderen statischen elektrischen Spannung E1, E2 an die Elektroden der anderen zwei Generatoren G1, G2, G3, G4 zur Ausbildung einer statischen Biegedeformation in einem statischen Betriebsmodus.

Der dynamische Betriebsmodus und der statische Betriebsmodus werden unabhängig voneinander ausgeführt, und können vorzugsweise derart hintereinander ausgeführt werden, dass dem dynamischen Betriebsmodus der statische Betriebsmodus folgt.

Innerhalb des dynamischen Betriebsmodus' wird entweder die einzige Wechselspannung U1 gleichzeitig an zwei der vier Generatoren G1, G2, G3, G4 oder jede der beiden Wechselspannungen U1, U2 an ein Generatorenpaar bestehend aus zwei zusammenwirkenden Generatoren, also beispielsweise U1 an G1 und G4 und U2 an G2 und G3, zur Ausbildung einer akustischen Stehwelle in dem Ultraschallaktuator angelegt, während in einem statischen Betriebsmodus die zwei statischen elektrischen Spannungen E1, E2 gleichzeitig an alle vier Generatoren G1, G2, G3, G4 zur Ausbildung einer statischen Biegedeformation des Ultraschallaktuators angelegt werden.

Es kann von Vorteil sein, dass in dem dynamischen Betriebsmodus beim Anlegen der zwei Wechselspannungen U1, U2 jedes der beiden Generatorenpaare, an welchem jeweils die gleiche Wechselspannung U1, U2 anliegt, eine akustische Stehwelle in dem Ultraschallaktuator ausbildet, welche einer Überlagerung der zweiten Mode einer Biege-Stehwelle und der ersten Mode einer Längs-Stehwelle entspricht.

Es kann aber auch von Vorteil sein, dass in dem dynamischen Betriebsmodus beim Anlegen der zwei Wechselspannungen U1, U2 eines der beiden Generatorenpaare, an welchem eine der Wechselspannungen U1, U2 anliegt, eine akustische Stehwelle in dem Ultraschallaktuator ausbildet, welche der zweiten Mode einer Biege-Stehwelle entspricht, und das andere der beiden Generatorenpaare, an welchem die andere Wechselspannung U1, U2 anliegt, eine akustische Stehwelle in dem Ultraschallaktuator ausbildet, welche der ersten Mode einer akustischen Längs-Stehwelle entspricht.

Es kann vorteilhaft sein, dass die statische Biegedeformation des Ultraschallaktuators in einer Ebene erfolgt, die im Wesentlichen parallel zu den Stirnflächen verläuft.

Es kann zudem von Vorteil sein, dass das Verhältnis von der Länge L zu der Dicke D des Ultraschallaktuators im Bereich zwischen 3,5 und 4,5 liegt.

Ebenso kann es von Vorteil sein, dass die Oberflächen, welche durch die elliptischen Bewegungsbahnen von Punkten des Friktionselements oder durch die Bewegungsrichtung eines durch den Ultraschallmotor anzutreibenden Elements gebildet sind, senkrecht zu den Hauptflächen des Ultraschallaktuators angeordnet sind.

Ferner kann es von Vorteil sein, dass die Generatoren G1, G2, G3, G4 zur Ausbildung akustischer Stehwellen und zur Ausbildung statischer Biegedeformationen jeweils gebildet sind durch auf den beiden Hauptflächen abwechselnd angeordnete streifenförmige Erregerelektroden und streifenförmige allgemeine Elektroden, wobei die streifenförmigen Elektroden parallel zur Quersymmetrieebene S1 verlaufen und die Polarisationsrichtung des zwischen den streifenförmigen Elektroden angeordneten piezoelektrischen oder elektrostriktiven oder magnetostriktiven Materials senkrecht zu den streifenförmigen Elektroden verläuft.

Hierbei kann es von Vorteil sein, dass der Abstand zwischen benachbarten streifenförmigen Elektroden gleich oder kleiner als die halbe Dicke D des Ultraschallaktuators ist.

Daneben kann es von Vorteil sein, dass die Generatoren zur Ausbildung akustischer Stehwellen und zur Ausbildung statischer Biegedeformationen gebildet sind aus flächigen, voneinander getrennten und auf den beiden Hauptflächen angeordneten Erregerelektroden und einer einzigen flächigen allgemeinen Elektrode, die innerhalb des Ultraschallaktuators mit dessen Längssymmetrieebene S2 zusammenfallend angeordnet ist, wobei die Polarisationsrichtung des zwischen den flächigen Elektroden angeordneten piezoelektrischen oder elektrostriktiven oder magnetostriktiven Materials senkrecht zu den flächigen Elektroden verläuft.

Darüber hinaus kann es von Vorteil sein, dass der Ultraschallmotor Klemmelemente zum Halten des Ultraschallaktuators aufweist, wobei die Klemmelemente in Bereichen der Minima der Schwingungsgeschwindigkeiten von in dem Ultraschallaktuator angeregten akustischen Biege-Stehwellen angeordnet sind.

Weitere Einzelheiten der Erfindung werden in den Zeichnungen anhand schematisch dargestellter Ausführungsbeispiele beschrieben. Es zeigen:
Figur 1: Ausführungsform eines zum Betrieb nach dem erfindungsgemäßen Verfahren geeigneten Ultraschallmotors in Form eines Linearantriebs
Figur 2: Ausführungsform eines zum Betrieb nach dem erfindungsgemäßen Verfahren geeigneten Ultraschallmotors in Form eines Rotationsantriebs
Figur 3: Geometrischer Aufbau eines zum Betrieb mit dem erfindungsgemäßen Verfahren geeigneten Ultraschallaktuators eines Ultraschallmotors
Figur 4: Ultraschallaktuator gemäß Fig. 3 mit einem an einer seiner Stirnflächen angeordneten Friktionselement
Figur 5, Darstellungen 23 bis 26: unterschiedliche Ansichten eines Ultraschallaktuators gemäß den Figuren 3 und 4 mit einer möglichen Ausführungsform für die Elektroden des Ultraschallaktuators
Figur 6, Darstellungen 34 bis 37: unterschiedliche Ansichten eines Ultraschallaktuators gemäß den Figuren 3 und 4 mit einer weiteren möglichen Ausführungsform für die Elektroden des Ultraschallaktuators
Figur 7, Darstellung 46: perspektivische Ansicht des Ultraschallaktuators gemäß Figur 5 mit an einer seiner Stirnseiten angeordnetem Friktionselement; Darstellung 47: perspektivische Ansicht des Ultraschallaktuators gemäß Figur 6 mit an einer seiner Stirnseiten angeordnetem Friktionselement
Figur 8, Darstellung 48: elektrische Schaltung zum Betrieb des Ultraschallaktuators gemäß Figur 5 mit dem erfindungsgemäßen Verfahren unter Verwendung einer einzigen Wechselspannung U1; Darstellung 49: Blockschaltbild mit einer elektrischen Erregervorrichtung zur Durchführung des erfindungsgemäßen Verfahrens unter Verwendung einer einzigen Wechselspannung U1
Figur 9, Abbildungen 66 und 67: Zustände maximaler Deformation aufgrund der in einem nach dem erfindungsgemäßen Verfahren angesteuerten Ultraschallaktuator ausgebildeten 2. Mode einer Biege-Stehwelle (dynamischer Betriebsmodus); Abbildungen 68 und 69: Zustände maximaler Deformation aufgrund der in einem nach dem erfindungsgemäßen Verfahren angesteuerten Ultraschallaktuator ausgebildeten 1. Mode einer Längs-Stehwelle (dynamischer Betriebsmodus)
Figur 10: Darstellung einer möglichen Bewegungstrajektorie eines Punktes des Friktionselements eines nach dem erfindungsgemäßen Verfahren angesteuerten Ultraschallaktuators (dynamischer Betriebsmodus)
Figur 11, Darstellungen 73 und 74: Zustände maximaler Deformation aufgrund der in einem nach dem erfindungsgemäßen Verfahren angesteuerten Ultraschallaktuator ausgebildeten statischen Biegedeformation (statischer Betriebsmodus)
Figur 12: Darstellung einer möglichen Bewegungstrajektorie eines Punktes des Friktionselements eines nach dem erfindungsgemäßen Verfahren angesteuerten Ultraschallaktuators (statischer Betriebsmodus)
Figur 13, Darstellung 78: elektrische Schaltung zum Betrieb des Ultraschallaktuators gemäß Figur 5 mit dem erfindungsgemäßen Verfahren unter Verwendung von zwei Wechselspannungen U1 und U2; Darstellung 79: Blockschaltbild mit einer elektrischen Erregervorrichtung zur Durchführung des erfindungsgemäßen Verfahrens unter Verwendung von zwei Wechselspannungen U1 und U2
Figur 14: Darstellung 83: elektrische Schaltung zum Betrieb des Ultraschallaktuators gemäß Figur 5 mit dem erfindungsgemäßen Verfahren unter Verwendung von zwei Wechselspannungen U1 und U2, wobei jede der Wechselspannungen eine unabhängige Stehwelle in dem Ultraschallaktuator generiert; Darstellung 84: Blockschaltbild mit einer elektrischen Erregervorrichtung zur Durchführung des erfindungsgemäßen Verfahrens unter Verwendung von zwei Wechselspannungen U1 und U2
Figur 15, Darstellung 85: elektrische Schaltung zum Betrieb des Ultraschallaktuators gemäß Figur 6 mit dem erfindungsgemäßen Verfahren unter Verwendung einer einzigen Wechselspannung U1; Darstellung 86: Blockschaltbild mit einer elektrischen Erregervorrichtung zur Durchführung des erfindungsgemäßen Verfahrens unter Verwendung einer einzigen Wechselspannung U1
Figur 16, Darstellung 87: elektrische Schaltung zum Betrieb des Ultraschallaktuators gemäß Figur 6 mit dem erfindungsgemäßen Verfahren unter Verwendung von zwei Wechselspannungen U1 und U2; Darstellung 88: Blockschaltbild mit einer elektrischen Erregervorrichtung zur Durchführung des erfindungsgemäßen Verfahrens unter Verwendung von zwei Wechselspannungen U1 und U2
Figur 17, Darstellung 89: elektrische Schaltung zum Betrieb des Ultraschallaktuators gemäß Figur 6 mit dem erfindungsgemäßen Verfahren unter Verwendung von zwei Wechselspannungen U1 und U2, wobei jede der Wechselspannungen eine unabhängige Stehwelle in dem Ultraschallaktuator generiert; Darstellung 90: Blockschaltbild mit einer elektrischen Erregervorrichtung zur Durchführung des erfindungsgemäßen Verfahrens unter Verwendung von zwei Wechselspannungen U1 und U2
Figur 18: Ausführungsform eines zum Betrieb nach dem erfindungsgemäßen Verfahren geeigneten Ultraschallmotors in Form eines Linearantriebs

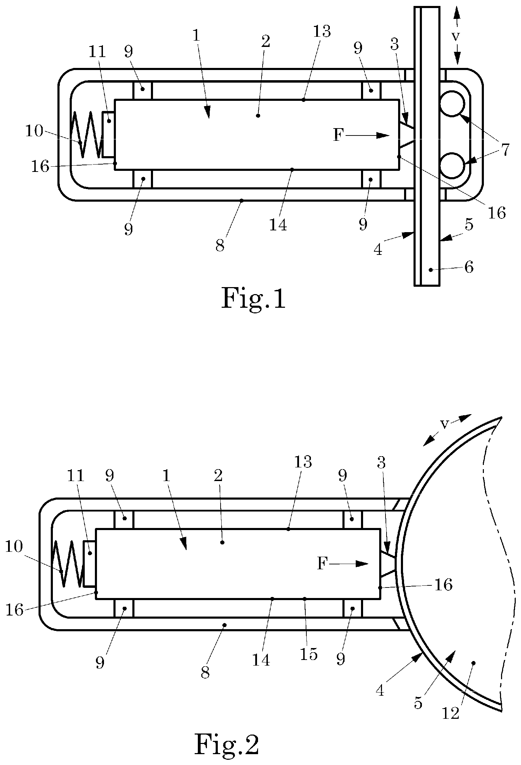

Figur 1 zeigt eine Ausführungsform eines zum Betrieb mit dem erfindungsgemäßen Verfahren geeigneten Ultraschallmotors in Form eines Linearantriebs. Der Ultraschallmotor umfasst einen Ultraschallaktuator 1 in Form einer rechteckigen piezoelektrischen Platte 2 mit zwei flächenmäßig größten Hauptflächen 13 und 14, zwei sich entlang der Länge des Ultraschallaktuators erstreckenden Seitenflächen 15 und zwei sich entlang der Breite des Ultraschallaktuators erstreckenden Stirnflächen 16. An der einem anzutreibenden Element 5 zugewandten Stirnfläche 16 ist ein Friktionselement 3 angebracht, dass mittels eines Federelements 10 mit einer Kraft F an die Friktionsoberfläche 4 des anzutreibenden Elements 5 angepresst ist.

Das anzutreibende Element 5 ist als ein in dem Gehäuse 8 mittels des Lagers 7 längs verschiebbar gelagerter Körper 6 ausgeführt.

Der Ultraschallaktuator 1 ist in dem Gehäuse 8 über Klemmelemente 9 gehalten.

Die durch das Federelement 10 erzeugte Anpresskraft F wirkt über die schalldämmende Unterlage 11 auf den Ultraschallaktuator 1.

Neben der in Figur 1 gezeigten Stabform des anzutreibenden Körpers 5 kann dieser auch als Platte, als Tisch oder in einer anderen ähnlichen Form ausgeführt sein.

Die Pfeile mit dem Index v geben die Bewegungsrichtung des anzutreibenden Elements 5 an.

Figur 2 zeigt eine weitere Ausführungsform eines zum Betrieb mit dem erfindungsgemäßen Verfahren geeigneten Ultraschallmotors in Form eines Rotationsantriebs, bei welchem das anzutreibende Element 5 als Dreh- oder Rotationskörper 12 in Form einer Scheibe ausgeführt ist.

Der Dreh- oder Rotationskörper 12 kann auch nur der Teil einer Scheibe sein, wobei darüber hinaus viele weitere Formen, wie etwa ein Ring oder ein Teil eines Ringes, ein Zylinder oder ein Teil eines Zylinders und eine Kugel oder ein Teil einer Kugel vorstellbar sind.

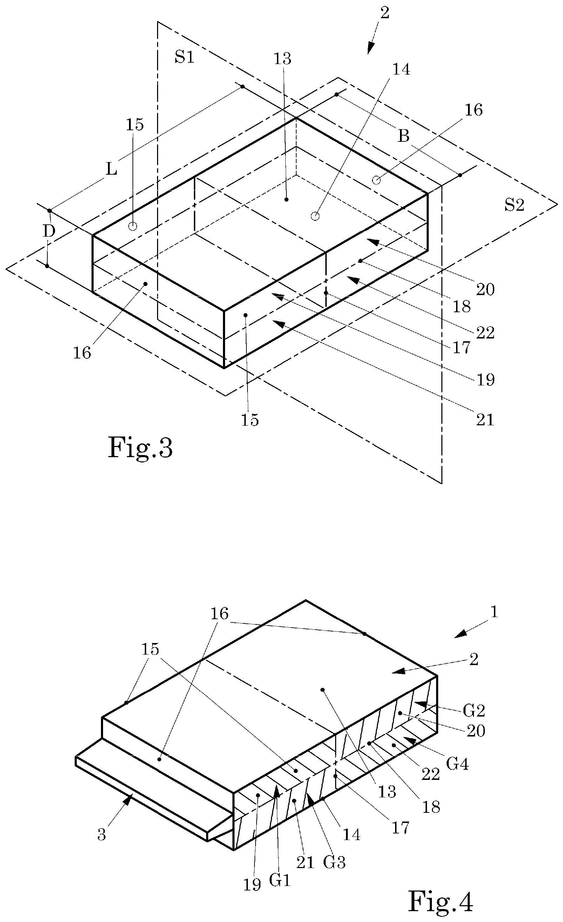

Figur 3 verdeutlicht den geometrischen Aufbau bzw. die geometrischen Verhältnisse eines zum Betrieb mit dem erfindungsgemäßen Verfahren geeigneten Ultraschallaktuators eines Ultraschallmotors. Der Ultraschallaktuator weist hierbei die Form einer rechteckigen Platte 2 auf, wobei die Platte vollständig aus piezoelektrischer Keramik gefertigt ist. Die piezoelektrische Platte 2 besitzt zwei Hauptflächen 13, 14, zwei Seitenflächen 15 und zwei Stirnflächen 16. Die Platte hat die Länge L, die Breite B und die Dicke D, wobei das Verhältnis von Länge L zu Dicke D zwischen 3,5 bis 4,5 liegt.

Das Längen-zu-Dicken-Verhältnis L/D bestimmt dabei die Lage der Resonanzfrequenz Fp2 der zweiten Mode der akustischen Biege-Stehwelle, die sich längs zur Länge L und längs zur Dicke D ausbreitet, relativ zur Resonanzfrequenz Fp1 der ersten Mode der akustischen Längs-Stehwelle, die sich längs der Länge L ausbreitet.

Bei einem Verhältnis L/D zwischen 3,5 und 4,5 liegen die Resonanzfrequenzen Fp2 und Fp1 nahe beieinander oder fallen zusammen.

Die Breite B der piezoelektrischen Platte 2 ist größer als ihre Dicke D und kleiner als ihre Länge L.

Die Platte 2 kann durch die virtuelle senkrechte Symmetrieebene S1 geteilt werden, die senkrecht zu den Seitenflächen 15 und parallel zu den Stirnflächen 16 verläuft. Die Symmetrieebene S1 teilt die Länge L und demgemäß die Hauptflächen 13, 14 der Platte 2 in zwei gleiche Teile.

Außerdem kann die Platte 2 durch die virtuelle Längssymmetrieebene S2 geteilt werden, die senkrecht zu den Stirnflächen 16 und parallel zu den Hauptebenen 13, 14 verläuft. Die Ebene S2 teilt die Dicke D und demgemäß die Stirnflächen 16 der Platte 2 in zwei gleiche Teile.

Die strichpunktierten Linien 17 und 18 verdeutlichen die Schnittlinie der Symmetrieebenen S1 und S2 mit den Oberflächen 13, 14, 15, 16 der Platte 2. Die beiden Ebenen S1 und S2 teilen die Platte 2 in die vier gleichen Volumenbereiche 19, 20, 21 und 22.

Figur 4 zeigt den Ultraschallaktuator gemäß Fig. 3 mit einem an einer seiner Stirnflächen 16 angeordneten Friktionselement 3.

Die Platte 2 des Ultraschallaktuators 1 ist in vier gleiche bzw. identische Volumenbereiche 19, 20, 21 und 22 geteilt, wobei jeder Volumenbereich zusammen mit in Figur 4 nicht gezeigten entsprechenden Elektroden einen Generator G1, G2, G3, G4 zur Ausbildung akustischer Stehwellen und zur Ausbildung statischer Biegedeformationen bildet. Hierbei kann der jeweilige Generator G1, G2, G3, G4 durch das gesamte Volumen des entsprechenden Volumenbereichs 19, 20, 21, 22, oder auch nur durch einen Teil des entsprechenden Volumenbereichs gebildet sein.

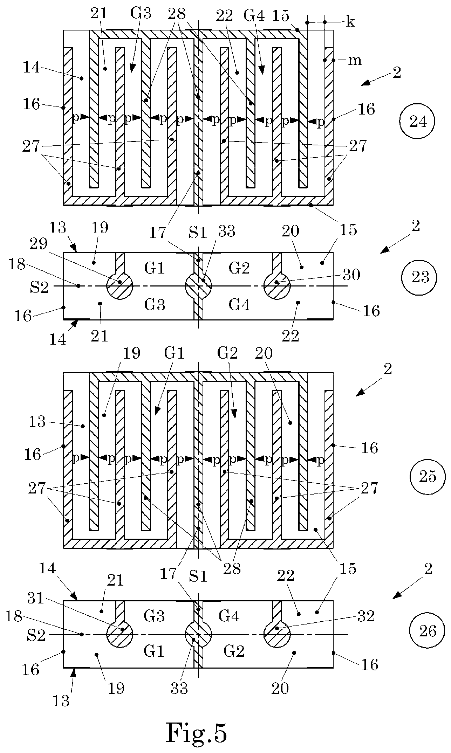

Figur 5 zeigt in den Darstellungen 23 bis 26 unterschiedliche Ansichten eines Ultraschallaktuators gemäß den Figuren 3 und 4 mit einer möglichen Ausführungsform für die Elektroden des Ultraschallaktuators.

Während die Darstellungen 23 und 26 die Elektrodenstruktur an den Seitenflächen 15 zeigen, verdeutlichen die Darstellungen 24 und 25 die Elektrodenstruktur an den Hauptflächen 13 und 14.

Die einzelnen Generatoren G1, G2, G3 und G4 umfassen streifenförmige Erregerelektroden 27 und streifenförmige allgemeine Elektroden 28, die auf den Hauptflächen 13 und 14 der Platte 2 angeordnet sind, wobei sich zwischen benachbarten streifenförmigen Elektroden 27, 28 piezoelektrisches bzw. piezokeramisches Material befindet. Die Pfeile mit dem Index p geben die Polarisationsrichtung der Piezokeramik zwischen den Elektroden 27 und 28 an.

Der Generator G1 umfasst streifenförmige Erregerelektroden 27 und streifenförmige allgemeine Elektroden 28, die auf der Hauptfläche 13 angeordnet und dem Volumenbereich 19 zuordnungsbar sind, sowie das piezokeramische Material, welches zwischen den streifenförmigen Elektroden 27 und 28 angeordnet ist.

Der Generator G2 umfasst streifenförmige Erregerelektroden 27 und streifenförmige allgemeine Elektroden 28, die auf der Hauptfläche 13 angeordnet und dem Volumenbereich 20 der Platte 2 zuordnungsbar sind, sowie der zwischen den Elektroden 27 und 28 angeordneten Piezokeramik.

Der Generator G3 umfasst streifenförmige Erregerelektroden 27 und streifenförmige allgemeine Elektroden 28, die auf der Hauptfläche 14 angeordnet und dem Volumenbereich 21 der Platte 2 zuordnungsbar sind, sowie der Piezokeramik, die zwischen den Elektroden 27 und 28 angeordnet ist.

Der Generator G4 schließlich umfasst streifenförmige Erregerelektroden 27 und streifenförmige allgemeine Elektroden 28, die auf der Hauptfläche 14 angeordnet und dem Volumenbereich 22 der Platte 2 zuordnungsbar sind, sowie der zwischen den Elektroden 27 und 28 angeordneten Piezokeramik.

Die streifenförmigen Erregerelektroden 27 des Generators G1 haben den auf der Seitenfläche 15 angeordneten Anschluss 29, während die streifenförmigen Erregerelektroden 27 des Generators G2 den auf der gleichen Seitenfläche 15 angeordneten Anschluss 30 besitzen.

Die streifenförmigen Erregerelektroden 27 des Generators G3 haben den Anschluss 31, und die streifenförmigen Erregerelektroden 27 des Generators G4 haben den Anschluss 32, wobei beide Anschlüsse 31 und 32 auf derselben Seitenfläche 15 angeordnet sind, die der Seitenfläche gegenüberliegt, an welcher die Anschlüsse 29 und 30 angeordnet sind.

Die allgemeinen streifenförmigen Elektroden 28 haben den Anschluss 33, welcher auf beiden Seitenflächen 15 angeordnet ist.

Alle streifenförmigen Elektroden 27 und 28 sind parallel zur Symmetrieebene S1 angeordnet, und die Polarisationsrichtung der Piezokeramik der piezoelektrischen Platte 2 zwischen den Elektroden 27 und 28 verläuft senkrecht zu den Elektroden 27 und 28.

Der Abstand k zwischen benachbarten streifenförmigen Erregerelektroden 27 und streifenförmigen allgemeinen Elektroden 28 ist gleich oder kleiner als die halbe Dicke D der piezoelektrischen Platte 2.

Die Breite m der streifenförmigen Elektroden 27 und 28 liegt im Bereich zwischen 0,1 und 0,5 mm.

Die streifenförmigen Elektroden 27 und 28 können auf die Hauptflächen 13 und 14 der Platte 2 durch einen chemischen Abscheidungsprozesses aus Nickel oder durch Vakuumabscheidung oder durch thermisches Abscheiden von Chrom, Kupfer oder Nickel oder auch durch Ionen-Plasma-Sputtern von Chrom, Kupfer, Nickel oder Gold aufgebracht werden. Die Struktur der streifenförmigen Elektroden 27 und 28 kann durch Laser-Fräsen, durch lithografisch-chemische Ätzung, durch Aufsprühen oder durch ein Maskendruckverfahren erzeugt werden.

Die Zahl der streifenförmigen Elektroden 27 und 28 auf den Oberflächen 13 und 14 wird lediglich durch die technologischen Fertigungsmöglichkeiten begrenzt.

Bei den Generatoren G1, G2, G3 und G4 mit den streifenförmigen Erregerelektroden und den allgemeinen Elektroden 27 und 28 gemäß Figur 5 wird zur Erregung der akustischen Stehwellen in dem Ultraschallaktuator der piezoelektrische Koeffizient d₃₃ genutzt.

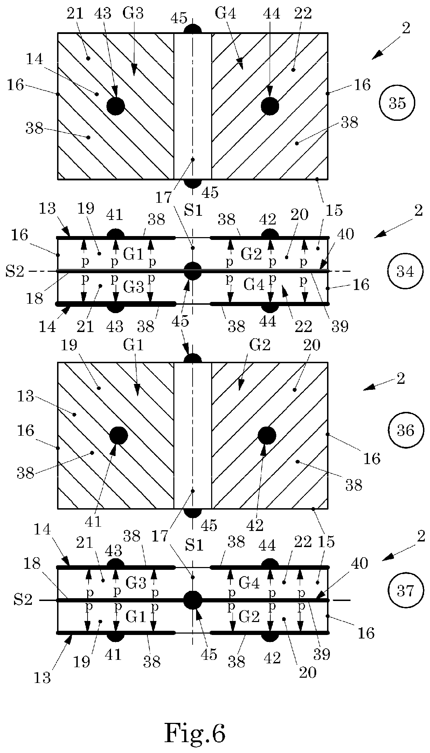

Figur 6 zeigt in den Darstellungen 34 bis 37 unterschiedliche Ansichten eines Ultraschallaktuators gemäß den Figuren 3 und 4 mit einer weiteren Ausführungsform für an dem Ultraschallaktuator angeordneten Elektroden.

Darstellung 34 von Figur 6 zeigt eine Seitenansicht des Ultraschallaktuators, Darstellung 35 die Ansicht der Unterseite des Ultraschallaktuators, Darstellung 36 die Ansicht der Oberseite des Ultraschallaktuators und Darstellung 37 zeigt die Ansicht der Seitenfläche 15, welcher der in Darstellung 34 gezeigten Seitenfläche gegenüberliegt.

Die einzelnen Generatoren G1, G2, G3 und G4 umfassen in diesem Ausführungsbeispiel eines Ultraschallaktuators eines erfindungsgemäßen Ultraschallmotors flächige Erregerelektroden 38, flächige allgemeine Elektroden 39 und das zwischen den Elektroden angeordnete piezokeramische Material.

Die flächigen Erregerelektroden 38 sind auf den Hauptflächen 13 und 14 beabstandet zueinander angeordnet, während die flächige allgemeine Elektrode 39 an der Innenfläche 40 der piezoelektrischen Platte 2, die mit der Längssymmetrieebene S2 zusammenfällt, angeordnet ist.

Die Polarisationsrichtungen des piezoelektrischen Materials des Ultraschallaktuators verlaufen jeweils senkrecht zu den flächigen Elektroden 38 und 39.

Der Generator G1 umfasst die an der Hauptfläche 13 angeordnete flächige Erregerelektrode 38, die dem Volumenbereich 19 der Platte 2 zuordnungsbar ist, und den dem Volumenbereich 19 zuordnungsbaren Abschnitt der an der Innenfläche 40 angeordneten flächigen allgemeinen Elektrode 39.

Der Generator G2 umfasst die an der Hauptfläche 13 angeordnete flächige Erregerelektrode 38, die dem Volumenbereich 20 der Platte 2 zuordnungsbar ist, und den dem Volumenbereich 20 zuordnungsbaren Abschnitt der an der Innenfläche 40 angeordneten flächigen allgemeinen Elektrode 39.

Der Generator G3 umfasst die an der Hauptfläche 14 angeordnete flächige Erregerelektrode 38, die dem Volumenbereich 21 der Platte 2 zuordnungsbar ist, und den dem Volumenbereich 21 zuordnungsbaren Abschnitt der an der Innenfläche 40 angeordneten flächigen allgemeinen Elektrode 39.

Der Generator G4 umfasst die an der Hauptfläche 14 angeordnete flächige Erregerelektrode 38, die dem Volumenbereich 22 der Platte 2 zuordnungsbar ist, und den dem Volumenbereich 22 zuordnungsbaren Abschnitt der an der Innenfläche 40 angeordneten flächigen allgemeinen Elektrode 39.

Die flächigen Erregerelektroden 38 der Generatoren G1, G2, G3 und G4 weisen jeweils einen im Wesentlichen mittig angeordneten elektrischen Anschluss 41, 42, 43 und 44 auf, während die flächige allgemeine Elektrode 39 über zwei elektrische Anschlüsse 45 verfügt, wobei jeder der elektrischen Anschlüsse an einer Seitenfläche 15 angeordnet ist.

Bei der Ausführungsform der Generatoren G1, G2, G3 und G4 mit flächigen Erregerelektroden 38 und flächigen allgemeinen Elektroden 39 gemäß Figur 6 wird zur Erregung der akustischen Stehwellen der piezoelektrische Koeffizient d₃₁ genutzt.

Die flächigen Erregerelektroden 38 können aus den Werkstoffen und nach den Technologien hergestellt werden wie zuvor für die streifenförmigen Erregerelektroden und allgemeinen Elektroden bezüglich Figur 5 beschrieben.

Die flächigen allgemeinen Elektroden 39 befinden sich auf der Innenfläche 40 und können aus Kupfer, Silber, Palladium oder einer Legierung in einer Inertgasatmosphäre durch ein Syntheseverfahren gemeinsam mit der Piezokeramik der piezokeramischen Platte 2 hergestellt werden. Die flächigen allgemeinen Elektroden 39 können auch aus elektrisch leitender Keramik hergestellt werden.

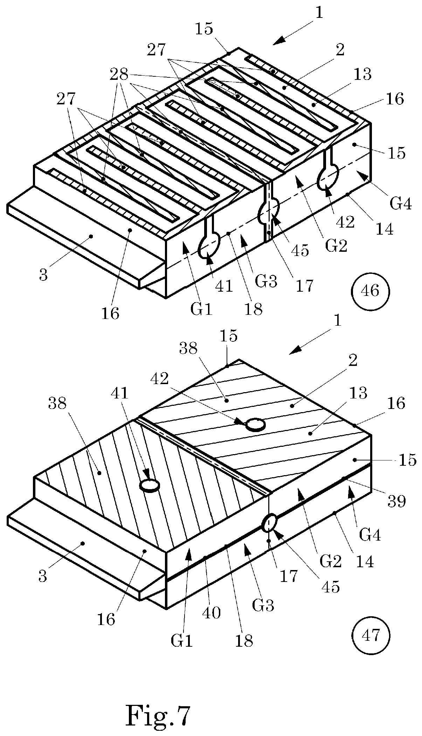

Darstellung 46 von Figur 7 zeigt in perspektivischer Ansicht den Ultraschallaktor gemäß Figur 5 mit an einer seiner Stirnseiten 16 angeordnetem Friktionselement 3, während Darstellung 47 von Figur 7 in perspektivischer Ansicht den Ultraschallaktor gemäß Figur 6 mit an einer seiner Stirnseiten 16 angeordnetem Friktionselement 3 zeigt. Hierbei ist zu erkennen, dass in beiden Fällen das Friktionselement 3 im Wesentlichen mittig bezüglich der Dicke D angeordnet ist und über die gesamte Breite B des Ultraschallaktors 1 verläuft.

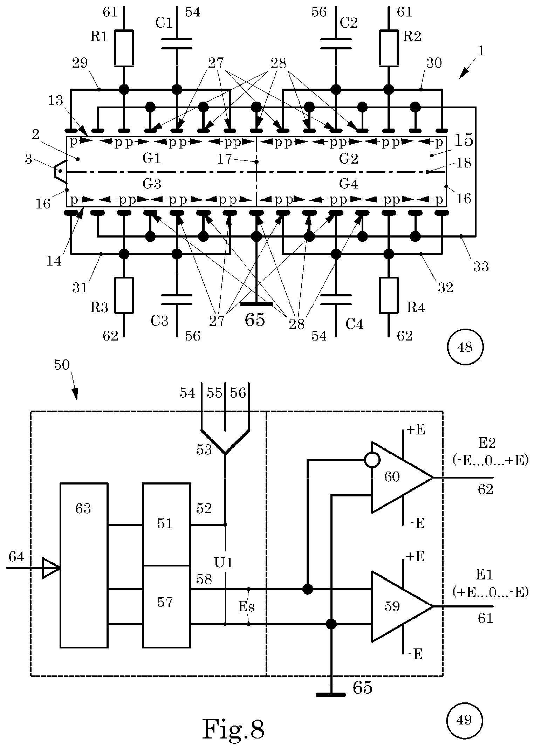

Darstellung 48 von Figur 8 zeigt eine elektrische Schaltung zum Betrieb des Ultraschallaktuators 1 gemäß Figur 5 mit dem erfindungsgemäßen Verfahren, wobei der Ultraschallaktuator 1 streifenförmige Erregerelektroden 27 und streifenförmige allgemeine Elektroden 28 aufweist, und die elektrische Schaltung Trennkondensatoren C1, C2, C3 und C4 und Trennwiderstände R1, R2, R3 und R4 umfasst.

Die Kapazität der Trennkondensatoren C1, C2, C3 und C4 ist vorzugsweise gleich oder größer als die elektrische Kapazität Co des Aktuators 1 zwischen den Elektroden 27 und 28 der Generatoren G1, G2, G3 und G4.

Die Trennwiderstände R1, R2, R3 und R4 haben vorzugsweise einen Wert, der 5 bis 10 mal größer als der charakteristische Widerstand Xo der Kapazität Co ist, mit Xo=1/2pFgCo, wobei Fg die Betriebsfrequenz des Ultraschallmotors ist.

Darstellung 49 von Figur 8 zeigt ein Blockschaltbild betreffend eine elektrische Erregervorrichtung 50 zur Durchführung des erfindungsgemäßen Verfahrens.

Die Erregervorrichtung 50 umfasst einen Einphasengenerator 51 für eine elektrische Wechselspannung U1 an dem Anschluss 52, einen Umschalter 53 mit den Anschlüssen 54, 55 und 56, einen elektrischen Generator 57 für eine statische elektrische Steuerspannung Es am Anschluss 58, Linearverstärker 59 und 60 für eine statische elektrische Spannung mit den Anschlüssen 61 und 62, an denen die statischen elektrischen Spannungen E1 und E2 anliegen und einen Controller 63 mit einem Eingang 64.

Alle Blöcke der Erregervorrichtung 50 haben den allgemeinen Ausgang 65.

Mittels der Erregervorrichtung 50 kann eine Steuerung sowohl im dynamischen Regime (dynamischer Betriebsmodus), als auch im statischen Regime (statischer Betriebsmodus) erfolgen.

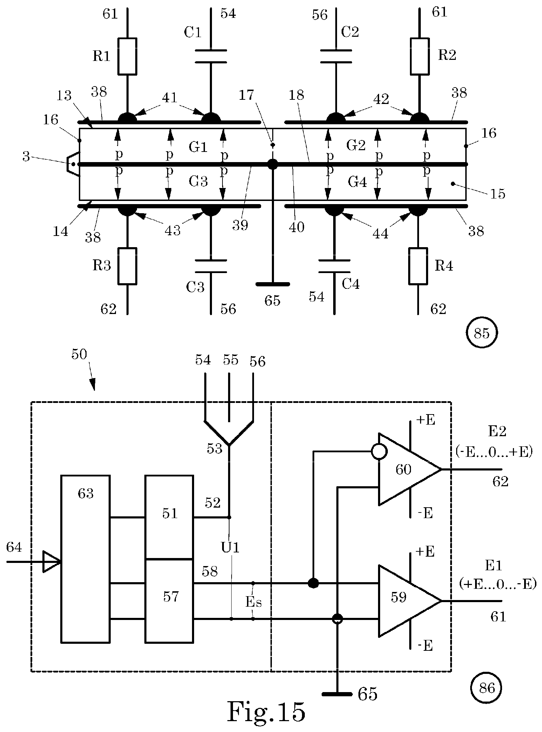

Bei einer dynamischen Einphasensteuerung gemäß Figur 8 bzw. Figur 15 stellt der Generator 51 die elektrische Einphasenwechselspannung U1 mit der Frequenz Fg bereit, die gleich der Frequenz Fp2 oder gleich der Frequenz Fp1 ist oder die zwischen diesen oder nahe zu diesen Frequenzen liegt.

Einerseits wird die Spannung U1 über den Anschluss 54 des Umschalters 53 und die Kondensatoren C1 und C4 an die Anschlüsse 29 und 32 der Erregerelektroden 27 der Generatoren G1 und G4 angelegt. Anderseits wird die Spannung U1 über den allgemeinen Ausgang 65 an den Eingang 33 der allgemeinen Elektroden 28 der Generatoren G1 und G4 angelegt.

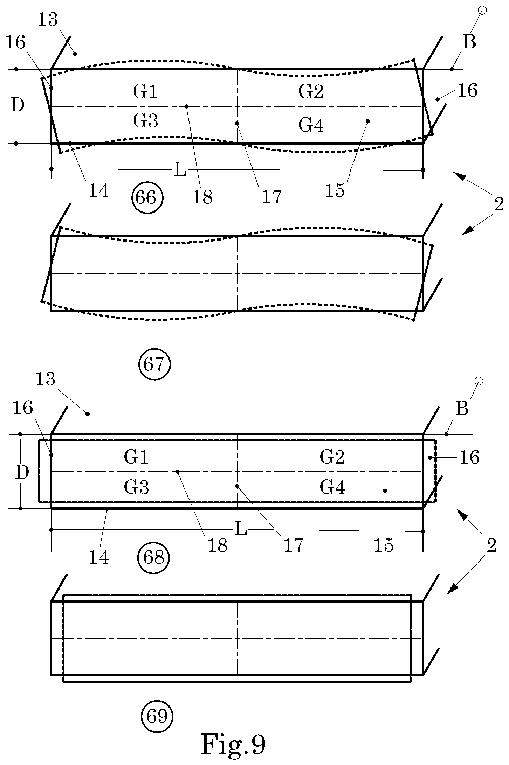

Die Spannung U1 steuert dynamisch die Generatoren G1 und G2 an, wodurch diese Generatoren gleichzeitig im Aktuator 1 die zweite Mode einer akustischen Biege-Stehwelle, die sich längs zur Länge L und längs zur Dicke D ausbreitet (siehe dazu auch die Darstellungen 66 und 67 in Figur 9), und die erste Mode einer akustischen Längs-Stehwelle, die sich längs zur Länge L ausbreitet (siehe dazu die Darstellungen 68 und 69 von Figur 9), erzeugen.

Die punktierten Linien in den Darstellungen 66 und 67 von Figur 9 zeigen die Form der maximalen Verformung der Platte 2, wenn sich in ihr die zweite Mode der akustischen Biege-Stehwelle ausbreitet.

Die punktierten Linien in den Darstellungen 68 und 69 von Figur 9 zeigen die Form der maximalen Verformung der Platte 2, wenn sich in ihr die erste Mode der akustischen Längs-Stehwelle ausbreitet.

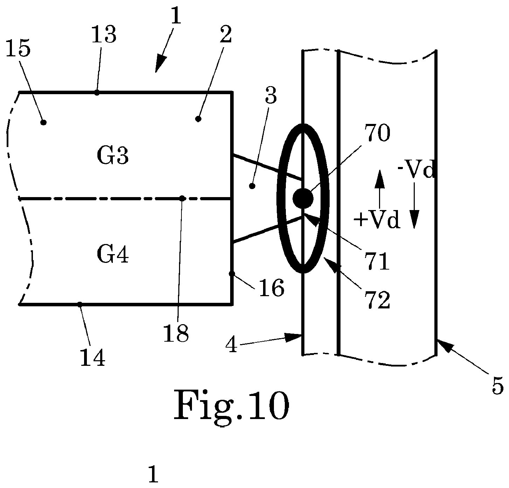

Die Überlagerung der Biege-Stehwelle und der Längs-Stehwelle führt dazu, dass sich der Punkt 70 (wie auch andere Punkte) der Friktionsoberfläche 71 des Friktionselements 3 stetig auf einer elliptischen Bewegungsbahn 72 in der mit den Pfeilen und dem Index +Vd angegebenen Richtung bewegt, wie dies in Figur 10 dargestellt ist. Die Form der Ellipse und deren Neigung zur Friktionsoberfläche 4 hängen dabei vom gewählten Verhältnis L/D ab.

Die elliptischen Bewegungsbahnen 72 des Punktes 70 und der anderen Punkte bildenden Oberflächen des Friktionselementes 3 liegen senkrecht zu den Hauptflächen 13 und 14 der piezoelektrischen Platte 2 des Aktuators 1.

Da die Friktionsoberfläche 71 des Friktionselementes 3 durch eine Kraft F an die Friktionsoberfläche 4 des anzutreibenden Elements 5 angepresst wird, führt die elliptische Bewegungsbahn 72 zu einer stetigen Bewegung des anzutreibenden Elements 5 in der durch den Pfeil mit dem Index +Vd angegebenen Richtung.

Beim Betätigen des Umschalters 53 in die Kontaktposition mit dem Anschluss 56 (punktierte Linie in Darstellung 49 von Figur 8) gelangt die elektrische Spannung U1 an die Anschlüsse 30 und 31 der Elektroden 27 und 28 der Generatoren G2 und G3, wodurch diese Generatoren dynamisch angeregt werden.

Dadurch erzeugen die Generatoren G2 und G3 gleichzeitig im Aktuator 1 die zweite Mode der akustischen Biege-Stehwelle, die sich längs der Länge L und längs zur Dicke D (siehe Darstellungen 66 und 67 von Figur 9) ausbreitet, und die erste Mode der akustischen Längs-Stehwelle, die sich längs zur Länge L (siehe Darstellungen 68 und 69 von Figur 9) ausbreitet.

Beim Betätigen des Umschalters 53 ändert sich die Phasenverschiebung zwischen der sich im Aktuator 1 ausbreitenden Biege-Stehwelle und der akustischen Längs-Stehwelle um 180°. Dadurch kehrt sich die Bewegungsrichtung der Punkte 70 auf ihren Bewegungsbahnen 72 um, dargestellt mit Pfeil und Index -Vd. Damit kehrt sich auch die Bewegungsrichtung des anzutreibenden Elements 5 um. Das anzutreibende Element bewegt sich dann in die mit Pfeil und Index -Vd angegebene Gegenrichtung.

Die Bewegungsrichtungen des anzutreibenden Elements 5 (in den Figuren 1, 2, 10, 12 und 18 dargestellt mit Pfeil und Index V oder Vd) verlaufen senkrecht zu den Hauptflächen 13 und 14 der piezoelektrischen Platte 2 des Aktuators 1.

Bei dem dynamischen Betriebsmodus des erfindungsgemäßen Verfahrens ist der Antriebsweg des anzutreibenden Elements 5 prinzipiell unbegrenzt, während ein minimaler Antriebsschritt des anzutreibenden Elements 5 durch die Oberflächenrauheit der Friktionsoberflächen 71 und 4 des Friktionselementes 3 und des anzutreibenden Elements 5 bestimmt ist. Im optimalen Fall beträgt die Länge eines Antriebsschrittes zwischen 0,05 und 0,1 µm.

Der statische Betriebsmodus des erfindungsgemäßen Verfahrens gestaltet sich wie folgt: zunächst wird der dynamische Betriebsmodus durch Überführen des Umschalters 53 in die Kontaktposition mit dem Anschluss 55 gestoppt. In dieser Position des Umschalters 53 werden die Generatoren G1, G2, G3 und G4 nicht mehr dynamisch angesteuert, da die elektrische Spannung U1 nicht an den Elektroden 27 und 28 anliegt.

Der Generator für die dynamische elektrische Spannung 57 stellt am Anschluss 58 die statische elektrische Steuerspannung Es bereit, die sich im Bereich von +Es über den Wert 0 bis -Es ändern kann. Diese Spannung wird durch die Linearverstärker 59 und 60 verstärkt.

Dadurch liegt am Anschluss 61 des Verstärkers 59 die statische elektrische Spannung E1 an, die sich im Bereich von +E über den Wert 0 bis -E ändert. Am Anschluss 62 des Verstärkers 60 liegt die invertierte statische elektrische Spannung E2 an, die sich im Bereich zwischen -E und +E ändert.

Zum Einen gelangt die Spannung E1 über die Widerstände R1 und R2 an die Anschlüsse 29 und 30 der Erregerelektroden 27 der Generatoren G1 und G2. Zum Anderen gelangt die Spannung E1 über den allgemeinen Anschluss 65 an den Anschluss 33 der allgemeinen Elektroden 28 der Generatoren G1 und G2.

Weiterhin gelangt die Spannung E2 über die Widerstände R3 und R4 an die Anschlüsse 29 und 30 der Erregerelektroden 27 der Generatoren G3 und G4, und andererseits gelangt die Spannung E2 über den allgemeinen Anschluss 65 an den Anschluss 33 der allgemeinen Elektroden 28 der Generatoren G3 und G4.

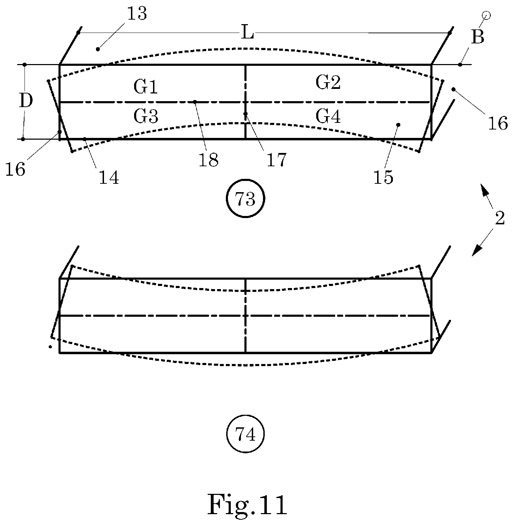

Die an den Generatoren G1, G2 und G3, G4 des Aktuators anliegenden elektrischen Spannungen E1 und E2 führen dazu, dass die piezoelektrische Platte 2 statisch gebogen bzw. deformiert wird, wie anhand der punktierten Linien in den Darstellungen 73 und 74 von Figur 11 gezeigt.

Die Richtung der statischen Biegung wird durch die Polarität der Spannung E1 im Verhältnis zur Polarität der Spannung E2 bestimmt. Die Größe der statischen Biegung wird durch die Größe der Spannungen E1 und E2 bestimmt.

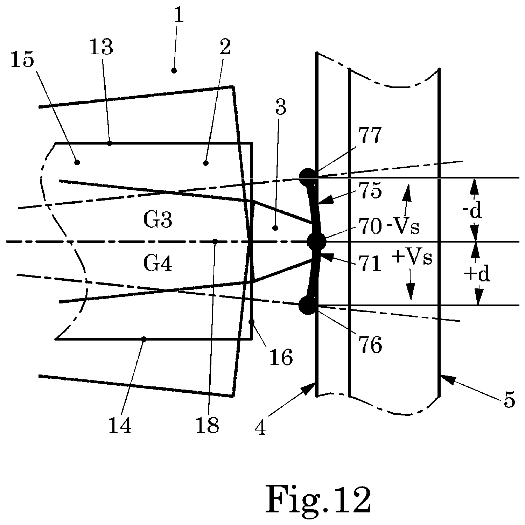

Wenn die Spannung E1 gleich der Spannung +E ist und die Spannung E2 gleich der Spannung -E, biegt sich die Platte 2 so, wie in Darstellung 73 von Figur 11 gezeigt. Dabei bewegt sich der Punkt 70 auf der Friktionsoberfläche 71 des Friktionselements 3 auf der Bahn 75 nach der Position 76, wie in Figur 12 dargestellt.

Da die Friktionsoberfläche 71 des Friktionselementes 3 durch eine Kraft F an die Friktionsoberfläche 4 des anzutreibenden Elementes 5 gepresst ist, führt die Verschiebung des Punktes 70 zu der Position 76 zu einer Translation des anzutreibenden Elements 5 um den Abstand +d in der mit Pfeil und Index +Vs angegebenen Richtung.

Bei einer Änderung der Polarität (E1 gleich -E und E2 gleich -E) biegt sich die Platte 2 so, wie in Darstellung 74 von Figur 11 gezeigt. In diesem Fall verschiebt sich der Punkt 70 auf der Friktionsoberfläche 71 des Friktionselementes 3 auf der Bahn 75 zu der Position 77 (siehe hierzu Figur 12).

Die Verschiebung des Punktes 70 zu der Position 77 führt zu einer Translation des anzutreibenden Elements 5 um den Abstand -d in der mit Pfeil und Index -Vs dargestellten Richtung.

Bei dem statischen Betriebsmodus des erfindungsgemäßen Verfahrens beträgt die maximale Verschiebung von +/-d, d.h. die maximale Schrittlänge des anzutreibenden Elementes 5 wird durch den Maximalwert der Spannungen E1 und E2 bestimmt. Die maximale Schrittlänge kann Werte zwischen 0,1 und 1 µm erreichen.

Die minimale Schrittlänge wird durch die Steifheit der Konstruktion der Klemmelemente 9 bestimmt. Sie kann im Bereich von zwischen 0.1 und 1nm liegen.

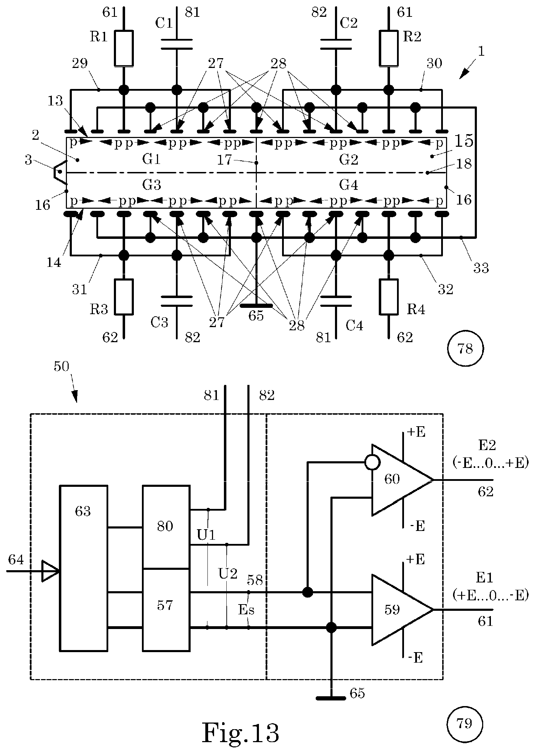

Der dynamische Betriebsmodus des erfindungsgemäßen Verfahrens kann ebenso mittels einer elektrischen Zwei-Phasen-Spannung realisiert werden. Die Darstellungen 78 und 79 von Figur 13 zeigen eine entsprechende elektrische Schaltung bzw. ein entsprechendes Blockschaltbild.

Bei einer Zweiphasensteuerung stellt der Generator 80 zwei elektrische Wechselspannungen U1 und U2 mit der gleichen Frequenz Fg für die Anschlüsse 81 und 82 bereit.

Die Spannungen U1 und U2 sind zueinander um den Phasenwinkel fg +/-90° oder um einen dazu abweichenden Winkel verschoben.

Zum Einen wird die Spannung U1 über den Anschluss 81 und die Kondensatoren C1 und C4 an die Anschlüsse 29 und 32 der Erregerelektroden 27 der Generatoren G1 und G4 gelegt, und zum Anderen gelangt die Spannung U1 über den allgemeinen Anschluss 65 an den Anschluss 33 der allgemeinen Elektroden 28 der Generatoren G1 und G4.

Weiterhin wird die Spannung U2 über den Anschluss 82 und die Kondensatoren C2 und C3 an die Anschlüsse 30 und 31 der Erregerelektroden 27 der Generatoren G2 und G3 gelegt, und die Spannung U2 gelangt über den allgemeinen Anschluss 65 an den Anschluss 33 der allgemeinen Elektroden 28 der Generatoren G2 und G3.

Jedes der beiden Generatorenpaare G1, G4 und G2, G3 erzeugt gleichzeitig im Aktuator 1 die zweite Mode einer akustischen Biege-Stehwelle, die sich längs zur Länge L und längs zur Dicke D (siehe Darstellungen 66 und 67 in Figur 9) ausbreitet, und die erste Mode einer akustischen Längs-Stehwelle, die sich längs zur Länge L ausbreitet (siehe Darstellungen 68 und 69 in Figur 9).

Die Überlagerung von akustischer Biege-Stehwelle und akustischer Längs-Stehwelle führt dazu, dass sich der Punkt 70 der Friktionsoberfläche 71 des Friktionselementes 3 stetig auf der elliptischen Bewegungsbahn 72 bewegt, wie in Figur 10 gezeigt. Dies führt zu einer Verschiebung bzw. zu einem Antrieb des anzutreibenden Elements 5.

Durch Umkehr des Phasenverschiebungswinkels fg wird die Bewegungsrichtung des anzutreibenden Elements geändert.

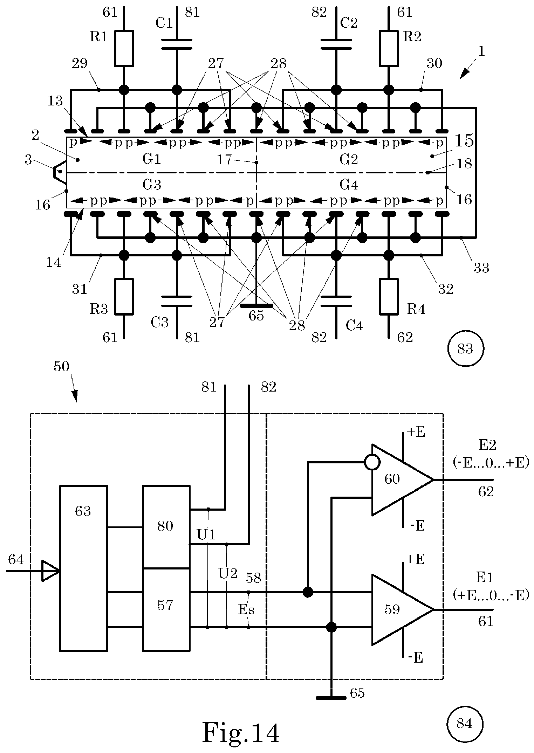

Weiterhin kann bei dem erfindungsgemäßen Verfahren der dynamische Betriebsmodus mit einer elektrischen Zweiphasenspannung mit unabhängiger gleichzeitiger Erzeugung von akustischen Stehwellen durch zwei Generatorenpaare, etwa G1 und G3 sowie G2 und G4, realisiert werden. Die Darstellungen 83 und 84 von Figur 14 zeigen eine entsprechende elektrische Schaltung für diese Erregungsform.

In diesem Fall bilden die Geratoren G1 und G3 gegenphasige Generatoren, und die Generatoren G2 und G4 stellen in Phase befindliche Generatoren dar.

Das Generatorenpaar G1, G3 erzeugt im Aktuator 1 die zweite Mode einer akustischen Biege-Stehwelle, die sich längs zur Länge L und längs zur Dicke D (siehe Darstellungen 66 und 67 von Figur 9) ausbreitet. Das Generatorenpaar G2, G4 erzeugt im Aktuator 1 die erste Mode einer akustischen Längs-Stehwelle, die sich längs zur Länge L (siehe Darstellungen 68 und 69 von Figur 9) ausbreitet.

Die Überlagerung von akustischer Biege- und Längs-Stehwelle führt dazu, dass sich die Punkte 70 der Friktionsoberfläche 71 des Friktionselementes 3 gemäß Figur 10 stetig auf der elliptischen Bewegungsbahn 72 bewegen. Daraus resultiert eine Antriebsbewegung des anzutreibenden Elements 5.

Die Darstellungen 85 und 86 von Figur 15 zeigen eine elektrische Schaltung zur Realisierung des erfindungsgemäßen Verfahrens mit einem Ultraschallaktuator 1, bei welchem die Generatoren G1, G2, G3 und G4 flächige Erregerelektroden 38 und flächige allgemeine Elektroden 39 gemäß Darstellung 47 von Figur 7 aufweisen. Hierbei erfolgt der dynamische Betriebsmodus mittels der elektrische Einphasenspannung U1.

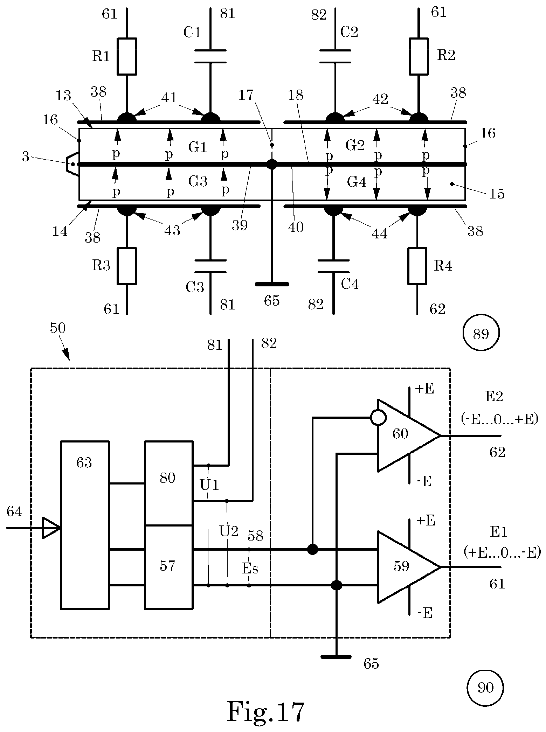

Das Funktionsprinzip der Schaltung gemäß Figur 17 ist analog zu dem in Figur 8 dargestellten Funktionsprinzip.

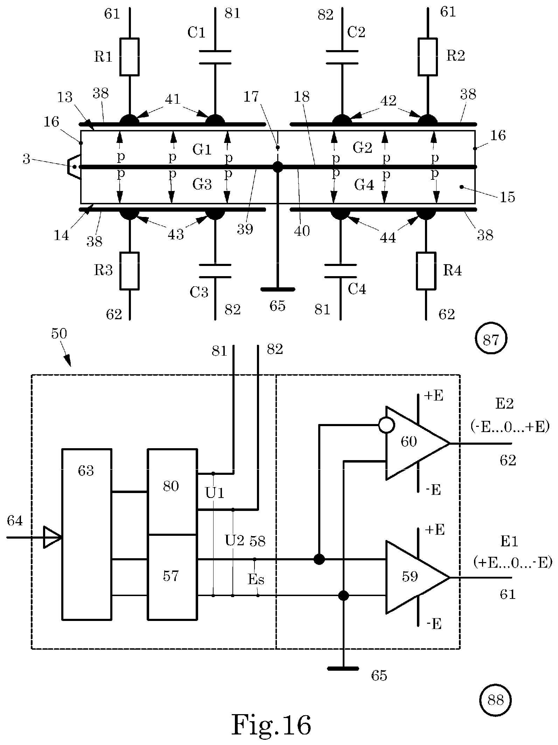

Die Darstellungen 87 und 88 von Figur 16 zeigen eine elektrische Schaltung zur Realisierung des dynamischen Betriebsmodus des erfindungsgemäßen Verfahrens mittels einer elektrischen Zweiphasenspannung U1, U2, wobei die Generatoren G1, G2, G3, G4 des angesteuerten Ultraschallaktuators 1 flächige Erregerelektroden 38 und flächige allgemeine Elektroden 39 aufweisen.

Das Funktionsprinzip der Schaltung in Figur 16 ist analog zu dem in Figur 13 dargestellten Funktionsprinzip.

Die Darstellungen 89 und 90 von Figur 17 zeigen eine elektrische Schaltung zur Realisierung des dynamischen Betriebsmodus des erfindungsgemäßen Verfahrens mittels einer elektrischen Zweiphasenspannung U1, U2, wobei die Generatoren G1, G3 und G2, G4 unabhängig voneinander erregt bzw. angeregt werden.

Das Funktionsprinzip der Schaltung in Figur17 ist anlog zu dem in Figur 14 dargestellten Funktionsprinzip.

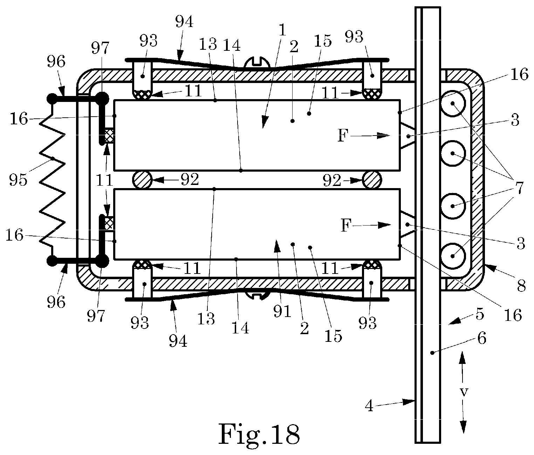

Figur 18 zeigt einen zum Betrieb nach dem erfindungsgemäßen Verfahren geeigneten Ultraschallmotor, der außer dem Hauptultraschallaktuator 1 einen zusätzlichen Ultraschallaktuator 91 aufweist.

In dieser Motorkonstruktion werden zur Fixierung der Aktuatoren 1 und 91 die fest mit dem Motorgehäuse 8 verbundenen Klemmelemente 92 eingesetzt. Die Aktuatoren 1 und 91 werden mit Hilfe der Anschläge 93 und der Flachfedern 94 von zwei gegenüberliegenden Seiten aus an die Klemmelemente 92 angepresst. Die Anschläge 93 berühren die Aktuatoren 1 und 91 in den Minima der Schwingungsgeschwindigkeiten der Biege-Stehwellen.

Das Andrücken der Friktionselemente 3 der Aktuatoren 1 und 91 an die Friktionsoberfläche 4 des anzutreibenden Elements 5 erfolgt mit Hilfe der Feder 95, die über die in den Achsen 97 gelagerten Hebel 96 auf die Aktuatoren 1 und 91 einwirkt.

Dadurch ist es möglich, die Kräfte F, welche die Friktionselemente 3 der Aktuatoren 1 und 91 an die Friktionsoberfläche 4 des anzutreibenden Elements 5 anpressen, genau auszubalancieren.

## Patentansprüche

1. Verfahren zum Betreiben eines Ultraschallmotors, umfassend folgende Schritte:
- Bereitstellen eines Ultraschallaktuators (1) aus einem piezoelektrischen oder elektrostriktiven oder magnetostriktiven Material in Form einer Platte (2), deren Breite B größer als deren Dicke D und kleiner als deren Länge L ist, und die Platte (2) zwei Hauptflächen (13,14), zwei sich entlang der Länge erstreckende Seitenflächen (15) und zwei sich entlang der Breite erstreckende Stirnflächen (16) aufweist, und die eine Quersymmetrieebene S1, die senkrecht zu den Hauptflächen (13, 14) und den Seitenflächen (15) und parallel zu den Stirnflächen (16) verläuft, und eine Längssymmetrieebene S2, die senkrecht zu den Seitenflächen (15) und den Stirnflächen (16) und parallel zu den Hauptflächen (13, 14) verläuft, besitzt, wobei an wenigstens einer der Stirnflächen (16) des Ultraschallaktuators (1) ein zu einem Kontakt mit einem anzutreibenden Element (5) vorgesehenes Friktionselement (3) angeordnet ist, und der Ultraschallaktuator vier identische Volumenbereiche (19, 20, 21 , 22) umfasst, die sowohl symmetrisch bezüglich der Quersymmetrieebene S1 als auch symmetrisch bezüglich der Längssymmetrieebene S2 angeordnet sind, und jeder der Volumenbereiche (19, 20, 21, 22) zusammen mit an und/oder in dem Ultraschallaktuator (1) angeordneten Erregerelektroden (27, 38) und allgemeinen Elektroden (28, 39) sowohl einen Generator (G1, G2, G3, G4) zur Ausbildung akustischer Stehwellen, als auch einen Generator (G1, G2, G3, G4) zur Ausbildung statischer Biegedeformationen bildet;
- Bereitstellen einer elektrischen Erregervorrichtung (50), welche eine elektrische Wechselspannung U1 oder zwei elektrische Wechselspannungen U1, U2 und zwei statische elektrische Spannungen E1, E2 liefert;
- Anlegen der Wechselspannung U1 an die Elektroden (27, 28, 38, 39) von zwei der vier Generatoren G1, G2, G3, G4 oder Anlegen einer der Wechselspannungen U1, U2 an die Elektroden (27, 28, 38, 39) von zwei der Generatoren G1, G2, G3, G4 und Anlegen der anderen Wechselspannung U1, U2 an die Elektroden (27, 28, 38, 39) der beiden anderen Generatoren G1, G2, G3, G4 zur Ausbildung einer akustischen Stehwelle in dem Ultraschallaktuator in einem dynamischen Betriebsmodus, oder Anlegen einer der beiden statischen elektrischen Spannungen E1, E2 an die Elektroden (27, 28, 38, 39) von zwei der vier Generatoren G1 , G2, G3, G4 und Anlegen der anderen statischen elektrischen Spannung E1, E2 an die Elektroden (27, 28, 38, 39) der anderen zwei Generatoren G1, G2, G3, G4 zur Ausbildung einer statischen Biegedeformation in einem statischen Betriebsmodus.

2. Verfahren nach Anspruch 1, **dadurch gekennzeichnet, dass** in dem dynamischen Betriebsmodus beim Anlegen der zwei Wechselspannungen U1, U2 jedes der beiden Generatorenpaare, an welchem jeweils die gleiche Wechselspannung U1, U2 anliegt, eine akustische Stehwelle in dem Ultraschallaktuator (1) ausbildet, welche einer Überlagerung der zweiten Mode einer Biege-Stehwelle und der ersten Mode einer Längs-Stehwelle entspricht.

3. Verfahren nach Anspruch 1, **dadurch gekennzeichnet, dass** in dem dynamischen Betriebsmodus beim Anlegen der zwei Wechselspannungen U1, U2 eines der beiden Generatorenpaare, an welchem eine der Wechselspannungen U1, U2 anliegt, eine akustische Stehwelle in dem Ultraschallaktuator (1) ausbildet, welche der zweiten Mode einer Biege- Stehwelle entspricht, und das andere der beiden Generatorenpaare, an welchem die andere Wechselspannung U1, U2 anliegt, eine akustische Stehwelle in dem Ultraschallaktuator (1) ausbildet, welche der ersten Mode einer akustischen Längs-Stehwelle entspricht.

4. Verfahren nach einem der vorhergehenden Ansprüche, **dadurch gekennzeichnet, dass** die statische Biegedeformation des Ultraschallaktuators (1) in einer Ebene erfolgt, die im Wesentlichen parallel zu den Stirnflächen (16) verläuft.

## Claims

1. Method for operating an ultrasonic motor, comprising the steps of:
- providing an ultrasonic actuator (1) made of piezoelectric or electrostrictive or magnetostrictive material in the form of a plate (2) whose width B is greater than its thickness D and smaller than its length L, and said plate (2) comprises two main faces (13,14), two side faces (15) extending along the length, and two end faces (16) extending along the width, and comprises a transverse plane of symmetry S1 which runs perpendicular to said main faces (13, 14) and said side faces (15) and parallel to said end faces (16), and a longitudinal plane of symmetry S2 which runs perpendicular to said side faces (15) and said end faces (16) and parallel to said main faces (13, 14), where a friction element (3) intended for contacting an element (5) to be driven is arranged on at least one of said end faces (16) of said ultrasonic actuator (1), and said ultrasonic actuator comprises four identical volume regions (19, 20, 21, 22) which are arranged symmetrically in relation to said transverse plane of symmetry S1 as well as symmetrically in relation to said longitudinal plane of symmetry S2, and each of said volume regions (19, 20, 21, 22) together with excitation electrodes (27, 38) and general electrodes (28, 39) arranged on and/or in said ultrasonic actuator (1) forms a generator (G1, G2, G3, G4) for forming acoustic standing waves as well as a generator (G1, G2, G3, G4) for forming static bending deformations;
- providing an electrical excitation device (50) which delivers one electric alternating voltage U1 or two electric alternating voltages U1, U2 and two static electric voltages E1, E2;
- applying said alternating voltage U1 to said electrodes (27, 28, 38, 39) of two of said four generators G1, G2, G3, G4 or applying one of said two alternating voltages U1, U2 to said electrodes (27, 28, 38, 39) of two of said generators G1, G2, G3, G4 and applying the other alternating voltage U1, U2 to said electrodes (27, 28, 38, 39) of said two other generators G1, G2, G3, G4 for forming an acoustic standing wave in said ultrasonic actuator in a dynamic operating mode, or applying one of said two static electric voltages E1, E2 to said electrodes (27, 28, 38, 39) of two of said four generators G1, G2, G3, G4 and applying said other static electric voltage E1, E2 to said electrodes (27, 28, 38, 39) of said other two generators G1, G2, G3, G4 for forming a static bending deformation in a static operating mode.

2. Method according to claim 1, **characterized in that** in the dynamic operating mode, when applying said two alternating voltages U1, U2, each of said two pairs of generators, to which the same alternating voltage U1, U2 is applied, forms an acoustic standing wave in said ultrasonic actuator (1) which corresponds to a superposition of the second mode of a bending standing wave and the first mode of a longitudinal standing wave.

3. Method according to claim 1, **characterized in that** in the dynamic operating mode, when applying said two alternating voltages U1, U2, one of said two pairs of generators, to which one of said alternating voltages U1, U2 is applied, forms an acoustic standing wave in said ultrasonic actuator (1) which corresponds to the second mode of a bending standing wave, and the other of said two pairs of generators, to which said other alternating voltage U1, U2 is applied, forms an acoustic standing wave in said ultrasonic actuator (1) which corresponds to the first mode of an acoustic longitudinal standing wave.

4. Method according to one of the preceding claims, **characterized in that** the static bending deformation of said ultrasonic actuator (1) takes place in a plane that runs substantially parallel to said end faces (16).

## Revendications

1. Procédé de fonctionnement d'un moteur à ultrasons, comprenant les étapes suivantes :
- fourniture d'un actionneur à ultrasons (1) constitué d'un matériau piézoélectrique, électrostrictif ou magnétostrictif sous la forme d'une plaque (2) dont la largeur B est supérieure à son épaisseur D et inférieure à sa longueur L, et dans lequel la plaque (2) présente deux faces principales (13, 14), deux faces latérales (15) qui s'étendent dans le sens de la longueur, et deux faces avant (16) qui s'étendent dans le sens de la largeur, et présente un plan de symétrie transversal S1 qui s'étend perpendiculairement aux faces principales (13, 14) et aux faces latérales (15) et parallèlement aux faces avant (16), et un plan de symétrie longitudinal S2 qui s'étend perpendiculairement aux faces latérales (15) et aux faces avant (16) et parallèlement aux faces principales (13, 14), dans lequel un élément de friction (3) destiné à entrer en contact avec un élément à entraîner (5) est agencé sur au moins l'une des faces avant (16) de l'actionneur à ultrasons (1), et l'actionneur à ultrasons comporte quatre régions volumiques identiques (19, 20, 21, 22) qui sont agencées à la fois symétriquement par rapport au plan de symétrie transversal S1 et symétriquement par rapport au plan de symétrie longitudinal S2, et chacune des régions volumiques (19, 20, 21, 22) constitue, conjointement à des électrodes d'excitation (27, 38) et à des électrodes générales (28, 39) agencées sur et/ou dans l'actionneur à ultrasons (1), un générateur (G1, G2, G3, G4) pour former des ondes stationnaires acoustiques ainsi qu'un générateur (G1, G2, G3, G4) destiné à former des déformations de flexion statiques ;
- fourniture d'un dispositif d'excitation électrique (50) qui procure une tension électrique alternative U1 ou deux tensions électriques alternatives U1, U2 et deux tensions électriques statiques E1, E2 ;
- application de la tension alternative U1 aux électrodes (27, 28, 38, 39) de deux des quatre générateurs G1, G2, G3, G4 ou application de l'une des tensions alternatives U1, U2 aux électrodes (27, 28, 38, 39) de deux des générateurs G1, G2, G3, G4 et application de l'autre tension alternative U1, U2 aux électrodes (27, 28, 38, 39) des deux autres générateurs G1, G2, G3, G4 pour former une onde stationnaire acoustique dans l'actionneur à ultrasons dans un mode de fonctionnement dynamique, ou application de l'une des deux tensions électriques statiques E1, E2 aux électrodes (27, 28, 38, 39) de deux des quatre générateurs G1, G2, G3, G4 et application de l'autre tension électrique statique E1, E2 aux électrodes (27, 28, 38, 39) des deux autres générateurs G1, G2, G3, G4 pour former une déformation de flexion statique dans un mode de fonctionnement statique.

2. Procédé selon la revendication 1, **caractérisé en ce que**, lors de l'application des deux tensions alternatives U1, U2 dans le mode de fonctionnement dynamique, chacune des deux paires de générateurs auxquelles est appliquée la même tension alternative U1, U2 forme une onde stationnaire acoustique dans l'actionneur à ultrasons (1) qui correspond à une superposition du deuxième mode d'une onde stationnaire de flexion et du premier mode d'une onde stationnaire longitudinale.

3. Procédé selon la revendication 1, **caractérisé en ce que**, lors de l'application des deux tensions alternatives U1, U2 dans le mode de fonctionnement dynamique, l'une des deux paires de générateurs à laquelle est appliquée l'une des tensions alternatives U1, U2 forme dans l'actionneur à ultrasons (1) une onde stationnaire acoustique qui correspond au deuxième mode d'une onde stationnaire de flexion, et l'autre des deux paires de générateurs à laquelle est appliquée l'autre tension alternative U1, U2 forme dans l'actionneur à ultrasons (1) une onde stationnaire acoustique qui correspond au premier mode d'une onde stationnaire longitudinale acoustique.

4. Procédé selon l'une des revendications précédentes, **caractérisé en ce que** la déformation de flexion statique de l'actionneur à ultrasons (1) a lieu dans un plan qui s'étend sensiblement parallèlement aux faces avant (16).
